# EUROPÄISCHE PATENTANMELDUNG

(11) **EP 0 735 811 A2**
(43) Veröffentlichungstag der Anmeldung: **02.10.1996**
(21) Anmeldenummer: 96103341.2
(22) Anmeldetag: 04.03.1996
(51) Int. Cl.: H05K 9/00

(54) **Abschirmung für Logik- und Hochfrequenzschaltkreise**

(30) Priorität: 29.03.1995 DE 29505327 U
(71) Anmelder: SIEMENS AKTIENGESELLSCHAFT, 80333 München (DE)
(72) Erfinder: Meschenmoser, Friedrich, Dipl.-Ing., 85630 Grasbrunn-Neukeferloh (DE)

(57) **Zusammenfassung**

Zur exakten Positionierung bei der Bestückung einer Leiterplatte (2) ist die dafür vorgesehene Metallkappe (1) an ihrer Stirnseite mit Nasen (5) versehen, welche in entsprechende Öffnungen der Leiterplatte (2) eingreifen.

## Beschreibung

Die vorliegende Erfindung betrifft eine Abschirmung für Logik- und Hochfrequenzschaltkreise in Kommunikationsendgeräten, insbesondere in Mobilfunkgeräten, bei welcher über der Fläche einer Leiterplatte, auf welcher die sich zu schirmenden Bauteile bzw. Baugruppen befinden, eine Metallkappe vorgesehen ist und die Stirnseiten der Metallkappe auf der Masseebene der Leiterplatte aufliegen und umlaufend mit dieser mittels Reflow-Lötung verbunden sind.

Eine derartige Abschirmung, welche mittels Reflow-Lötung mit der Leiterplatte verbunden ist, ist z.B. aus der EP-0 594 041 A1 bekannt. Bei derartigen Abschirmungen besteht ein großes Problem darin, diese wahrend des Bestückungsvorgangs exakt auszurichten. Da diese Abschirmungen nur stumpf aufgesetzt werden, kann es leicht zu Fehlern bei der Ausrichtung kommen.

Aufgabe der vorliegenden Erfindung ist es, eine Abschirmung der eingangs genannten Art anzugeben, welche eine exakte Positionierung der Abschirmung bei der Bestückung zuläßt.

Diese Aufgabe wird für die eingangs genannte Abschirmung erfindungsgemäß dadurch gelöst, daß zur Positionierung beim Bestücken der Leiterplatte an den Stirnseiten der Metallkappe Nasen vorgesehen sind, die in entsprechende Öffnungen in der Leiterplatte eingreifen.

Auf diese Weise wird durch die vorhandenen Nasen eine exakte Ausrichtung der Abschirmung während des Bestückungsvorgangs gewährleistet.

Eine zweckmäßige Ausgestaltung der erfindungsgemäßen Abschirmung ist dadurch gekennzeichnet, daß die Metallkappe an ihren Kanten Ausschnitte aufweist, welche fluchtend mit den Nasen angeordnet sind. Auf diese Weise können die Nasen, die zur Positionierung beim Bestücken der Leiterplatte verwendet werden, zusätzlich vorher zum Stapeln der Metallkappen benutzt werden.

Eine andere zweckmäßige Ausgestaltung der erfindungsgemäßen Abschirmung ist dadurch gekennzeichnet, daß zur Gewichtsreduzierung die Metallkappe mit Löchern versehen ist.

Die Erfindung wird nachfolgend anhand eines in der Zeichnung dargestellten Ausführungsbeispiels näher beschrieben.

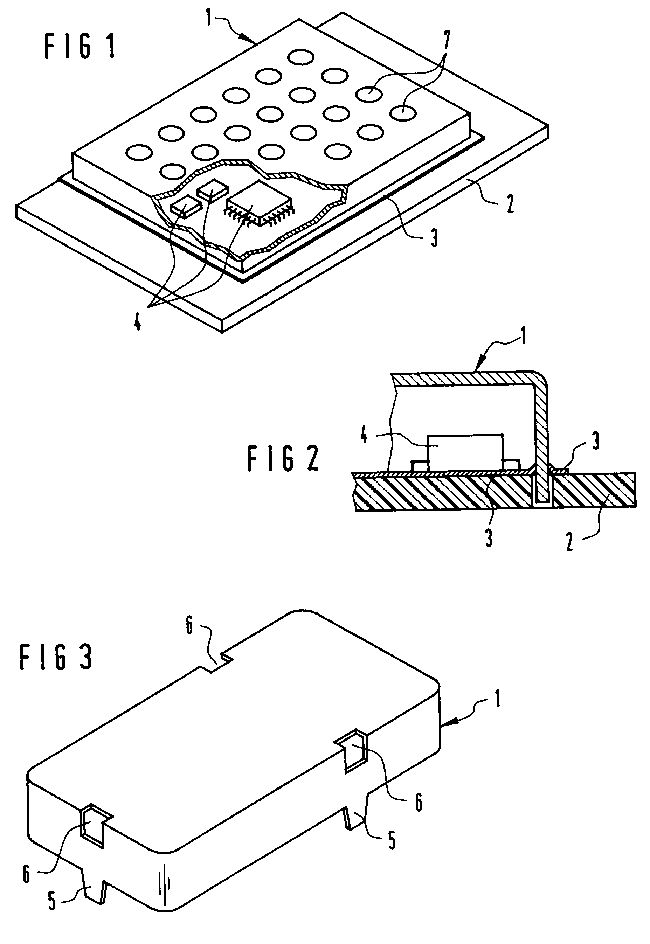

Es zeigen
- FIG 1: eine perspektifische Ansicht einer teilweise geschnittenen Metallkappe der vorliegenden Erfindung auf einer Leiterplatte,
- FIG 2: einen teilweisen Querschnitt durch eine Metallkappe, welche auf einer Leiterplatte befestigt ist,
- FIG 3: eine perspektifische Ansicht einer Metallkappe gemäß der vorliegenden Erfindung

Die Leiterplatte 2 ist mit Bauteilen bzw. Baugruppen 4 bestückt, welche HF-mäßig abgeschirmt werden müssen. Hierzu dient die Metallkappe 1. Zur exakten Positionierung während der Bestückung besitzt diese Metallkappe 1 an ihren Stirnseiten Nasen 5, welche in entsprechende Öffnungen in der Leiterplatte 2 eingreifen.

Fluchtend mit den Nasen 5 können in den Kanten der Metallkappe 1 Ausschnitte 6 vorgesehen werden. Auf diese Weise stehen die vorstehenden Nasen 5, welche zur Positionierung beim Bestücken der Leiterplatte verwendet werden, vorher zum Stapeln der Metallkappen 1 zur Verfügung. Auf diese Weise ermöglichen die Nasen 5 ein exaktes Stapeln der Metallkappen 1 während vor der eigentlichen Bestückungstätigkeit.

Zur Gewichtsreduzierung können in die Metallkappe 1 Löcher 7 ausgestanzt werden.

## Patentansprüche

1. Abschirmung für Logik- und Hochfrequenzschaltkreise in Kommunikationsendgeräten, insbesondere in Mobilfunkgeräten, bei welcher über der Fläche einer Leiterplatte, auf welcher sich die zu schirmenden Bauteile bzw. Baugruppen befinden, eine Metallkappe vorgesehen ist und die Stirnseiten der Metallkappe auf der Masseebene der Leiterplatte aufliegen und umlaufend mit dieser mittels Reflow-Lötung verbunden sind,
**dadurch gekennzeichnet,**
daß zur Positionierung beim Bestücken der Leiterplatte (2) an den Stirnseiten der Metallkappe (1) Nasen (5) vorgesehen sind, die in entsprechende Öffnungen in der Leiterplatte (2) eingreifen.

2. Abschirmung nach Anspruch 1,
**dadurch gekennzeichnet,**
daß die Metallkappe (1) an ihren Kanten Ausschnitte (6) aufweist, welche fluchtend mit den Nasen (5) angeordnet sind.

3. Abschirmung nach Anspruch 1 oder 2,
**dadurch gekennzeichnet,**
daß die Metallkappe (1) mit Löchern (7) versehen ist.
